# EUROPEAN PATENT APPLICATION

(11) **EP 4 708 363 A1**
(43) Date of publication of application: **11.03.2026**
(21) Application number: 24797369.6
(22) Date of filing: 23.04.2024
(51) Int. Cl.: H01L 27/146

(54) **METHOD FOR MANUFACTURING SENSING MATERIAL FOR THERMOGRAPHY IMAGE SENSOR AND THERMOGRAPHY IMAGE SENSOR COMPRISING SAME**

(30) Priority: 26.04.2023 KR 20230054558
(71) Applicant: Boda Inc., Pohang-si, Gyeongsangbuk-do 37673 (KR)
(72) Inventor: KIM, Hyung-Won, Hwaseong-si, Gyeonggi-do 18503 (KR)
(74) Representative: Maiwald GmbH
(86) International application number: PCT/KR2024/005437
(87) International publication number: WO 2024/225713

(57) **Abstract**

Provided are a method for manufacturing a sensing material for a thermography image sensor and a thermography image sensor comprising same. The present invention relates to a method for manufacturing a sensing material for a thermography image sensor, comprising the steps of: preparing a VTOP precursor; sequentially injecting the VTOP precursor and oxygen reaction gas into a chamber using a plasma enhanced atomic layer deposition (PE-ALD) method, and then forming an amorphous V₂O₅ oxide thin film in a plasma state; and preparing a crystalline VO₂ oxide thin film by heat-treating the formed amorphous V₂O₅ oxide thin film in a rapid thermal anneal (RTA) furnace in a reducing gas atmosphere.

## Description

### Technical Field

The present disclosure relates to a method for manufacturing a sensing material for thermography image sensing and a thermography image sensor including the sensing material manufactured thereby, and more specifically, to a method for manufacturing a sensing material for a thermography image sensor capable of providing a thermography image sensor having excellent characteristics by depositing amorphous V₂O₅ using an ALD method and heat-treating the same in a vacuum and reducing gas atmosphere, to manufacture a crystalline VO₂ sensing material, and a thermography image sensor including the same.

### Background Art

In general, a far-infrared sensor may be a sensor sensing far-infrared rays emitted by an object and measures the presence or absence of the object by using a magnitude of heat energy of the far-infrared rays. Such a far-infrared sensor may be applied in various fields. For example, such a far-infrared sensor may sense the presence or absence of people in automatic doors and automatically open and close the doors or turn lights on and off, may be applied to security devices that check for intrusions of an outsider into buildings in the middle of the night, may be applied to air conditioners sensing the presence or absence and location of human bodies and adjust a wind direction and a wind speed, or may be applied to others.

Conventionally, a far-infrared sensing element commonly used in the far-infrared sensor may include a heat absorption sensing element such as a pyroelectric, a thermopile, a bolometer, or the like. Among far-infrared sensing elements, the bolometer may be the one having the best performance and smallest volume that may be used for medium- and high-resolution images. The bolometer may absorb infrared rays emitted from an object and measure a change in electrical resistance due to a resulting increase in temperature, to detect the infrared rays. While other sensing elements exhibit a low infrared sensitivity of about 10⁷-10⁸cmHz^{1/2}W⁻¹, an infrared sensitivity of the bolometer may be about 10⁸-10⁹cmHz^{1/2}W⁻¹. A thermal sensing material of the bolometer requires high temperature coefficient of resistance (TCR) values, low element resistance, connectivity with IC processes, or the like.

Meanwhile, VO₂ (vanadium dioxide) may be mentioned as a thermal sensing material generally used in heat absorption sensing elements such as a bolometer or the like, and the vanadium dioxide may be a resistor having the characteristic of decreasing resistance when infrared rays (heat) are sensed. As may be well known, in order to obtain a uniform thermography image, resistance uniformity of vanadium dioxide within a manufacturing substrate or chip may be very important during a manufacturing process of a thermal sensing element.

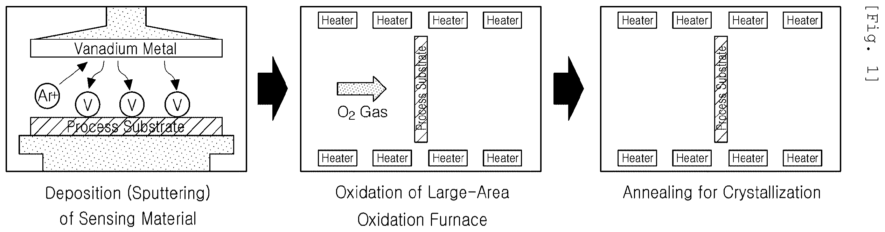

As a conventional method of forming vanadium dioxide, there may be provided a method of depositing metal vanadium through sputtering and then oxidizing the same in a high-temperature heat-treatment furnace of 400°C or higher. FIG. 1 is a view illustrating a method for forming a crystalline vanadium dioxide thin film as a thermal sensing material for a conventional thermal imaging sensor.

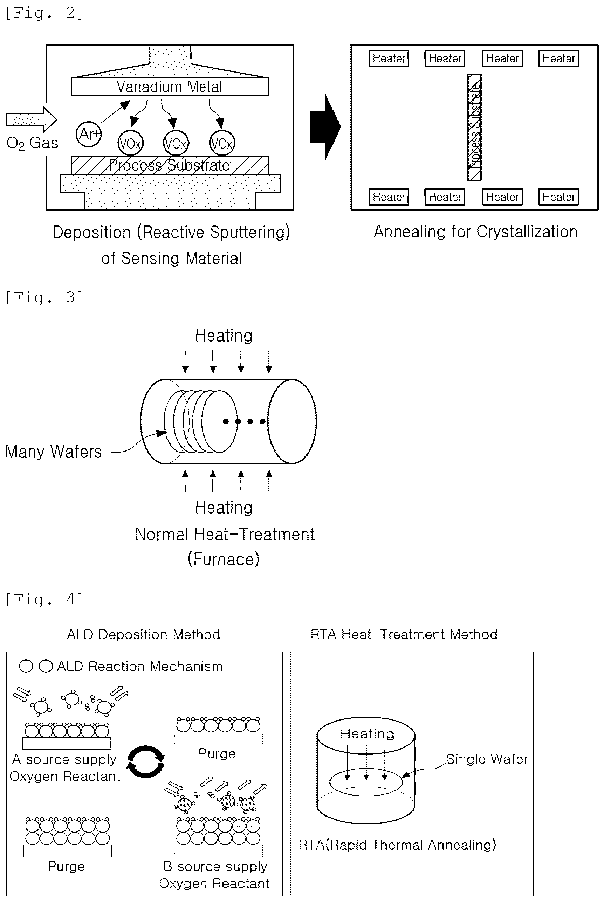

Another method may be a method using a reactive sputtering method in which oxygen gas is injected during sputtering deposition of metal vanadium and the oxygen is reacted at a high temperature of 400°C or higher, to be deposited. FIG. 2 is a view illustrating a method for forming a crystalline vanadium dioxide thin film as a thermal sensing material for a conventional thermal imaging sensor.

FIG. 3 is a detailed schematic diagram of the post-heat-treatment furnace of FIGS. 1 and 2.

A vanadium oxide formed by the manufacturing method may be a composite phase in which various vanadium oxide phases are mixed, rather than vanadium dioxide.

When the two methods are used, there may be a limitation in that resistance uniformity becomes very poor as a manufacturing substrate increases an area to have 8 inches. That is, in order to have excellent resistance uniformity on a large-area substrate, it may be necessary to deposit very thin vanadium dioxide very uniformly. However, it may be difficult to uniformly deposit a thickness of several tens of nanometers on the large area using a sputtering method, and as the substrate increases an area, a size of the heat-treatment furnace also increases, making it difficult to uniformly control a temperature and gas atmosphere in the furnace.

In addition, since the methods may have difficulties in controlling a composition of vanadium oxide, distribution of the composition in the thin film may be changed each time, making it difficult to match characteristics. Finally, there may be a problem that a process time may be very long because an annealing process for crystallizing a vanadium oxide thin film should be performed at a temperature of about 400°C in a subsequent process.

### Summary of Invention

### Technical Problem

The present disclosure aims to provide a method for forming a vanadium dioxide thin film as a sensing material for a thermography image sensor, which may not only have excellent resistance uniformity and uniform thin film characteristics, but may also shorten a post-treatment process time, and a thermography image sensor including the thin film as the sensing material, as compared to the conventional art described above.

In addition, the technical problems to be achieved in the present disclosure are not limited to the technical problems mentioned above, and other technical problems not mentioned herein would be clearly understood by a person having ordinary knowledge in the technical field to which the present disclosure belongs from the description below.

### Solution to Problem

An aspect of the present disclosure relates to a method for manufacturing a sensing material for a thermography image sensor, including:
preparing a VTOP precursor;
sequentially injecting the VTOP precursor and oxygen reaction gas into a chamber, and then forming an amorphous V₂O₅ oxide thin film in a plasma state using a plasma enhanced atomic layer deposition (PE-ALD) method; and
preparing a crystalline VO₂ oxide thin film by heat-treating the formed amorphous V₂O₅ oxide thin film in a rapid thermal anneal (RTA) furnace in a reducing gas atmosphere.

In addition, another aspect of the present disclosure relates to a thermography image sensor, including:
an ROIC substrate; a reflective layer formed on the ROIC substrate; a sensing layer formed in a space above the reflective layer; a support layer formed on a lower surface of the sensing layer to support the sensing layer; and a protective layer formed on an upper surface of the sensing layer,
wherein the support layer is configured such that the sensing layer can have a structure in which the space is floated, and
the sensing layer is formed as the crystalline VO₂ oxide thin film manufactured by the method.

In addition, another aspect of the present disclosure relates to a method for manufacturing a thermography image sensor, including:
preparing a ROIC substrate;
forming a reflective layer on the ROIC substrate;
forming a sacrificial layer on the substrate on which the reflective layer is formed, and then processing a VIA hole;
forming a support layer on the formed sacrificial layer;
forming an electrode layer at a predetermined position on the substrate on which the support layer is formed;
forming a VIA reinforcing layer on an outer surface of the VIA hole on which the electrode layer is formed;
forming a crystalline VO₂ oxide thin film, which is a sensing layer, on the substrate on which the VIA reinforcing layer is formed;
forming a protective layer on the substrate on which the sensing layer is formed; and
removing the sacrificial layer,
wherein the crystalline VO₂ oxide thin film, which is the sensing layer, is manufactured by a process including:
disposing the substrate on which the VIA reinforcing layer is formed in a chamber, sequentially injecting a VTOP precursor and oxygen reaction gas into the chamber, and then forming an amorphous V₂O₅ oxide thin film in a plasma state using a plasma enhanced atomic layer deposition (PE-ALD) method;
forming the crystalline VO₂ oxide thin film, which is the sensing layer, by heat-treating the substrate on which the amorphous V₂O₅ oxide thin film is formed in a rapid thermal anneal (RTA) furnace in a reducing gas atmosphere; and
forming the formed sensing layer as a pattern through a lithography process and an etching process.

### Advantageous Effects of Invention

As described above, the present disclosure uses an atomic layer deposition (ALD) method that may very uniformly deposit a thin film of several to several tens of nanometers on a wide substrate by depositing a single atomic layer at a time, in forming a sensing film for a thermography image sensor, thereby effectively achieving a non-uniformity of 1.9% when depositing 38 nm on an 8-inch wafer.

In addition, there may be advantages of increasing temperature uniformity and shortening a process time using rapid thermal annealing (RTA) equipment during post-heat-treatment, instead of a bulky oxidation heat-treatment furnace.

In addition, a reducing gas instead of oxygen may be used as a post-heat-treatment gas, a heat-treatment temperature may be lowered to 350°C or less, and furthermore, a crystalline vanadium dioxide film for a thermography image sensor in which crystallized vanadium dioxide occupies most of a phase may be effectively manufactured.

### Brief Description of Drawings

FIG. 1 is a view illustrating an example of a method for forming a crystalline vanadium dioxide thin film as a thermal sensing material for a conventional thermal imaging sensor.
FIG. 2 is a view illustrating another example of a method for forming a crystalline vanadium dioxide thin film as a thermal sensing material for a conventional thermal imaging sensor.
FIG. 3 is a detailed schematic diagram of the post-heat-treatment furnace of FIGS. 1 and 2.
FIG. 4 is a view illustrating a method for forming a crystalline vanadium dioxide thin film as a sensing material for a thermography image sensor, in an embodiment of the present disclosure.
FIG. 5 is a process schematic diagram illustrating a method for manufacturing a thermography image sensor including the vanadium dioxide thin film manufactured in FIG. 4 as a sensing material, in an embodiment of the present disclosure.
FIG. 6 is a view illustrating a resistance change rate of a vanadium dioxide thin film manufactured in an embodiment of the present disclosure.
FIG. 7 is a view illustrating a composition of a vanadium dioxide thin film manufactured in an embodiment of the present disclosure.
FIG. 8 is a view illustrating thickness uniformity of a vanadium dioxide thin film manufactured in an embodiment of the present disclosure.

### Best Mode for Invention

Hereinafter, the present disclosure will be described.

The present disclosure relates to a method for forming a vanadium dioxide thin film, which is a sensing material applicable to a thermography image sensor, and more specifically, to a method for forming a crystalline vanadium dioxide thin film, which is a sensing material for a thermography image sensor, by depositing an amorphous vanadium pentoxide (V₂O₅) thin film using an ALD method and then heat-treating the same in an RTA furnace in a reducing gas atmosphere, thereby not only having uniform resistance and uniform thin film properties but also shortening a post-treatment process time.

A method for manufacturing a sensing material for a thermography image sensor, according to the present disclosure, includes preparing a VTOP precursor; sequentially injecting the VTOP precursor and oxygen reaction gas into a chamber, and then forming an amorphous V₂O₅ oxide thin film in a plasma state using a plasma enhanced atomic layer deposition (PE-ALD) method; and preparing a crystalline VO₂ oxide thin film by heat-treating the formed amorphous V₂O₅ oxide thin film in a rapid thermal anneal (RTA) furnace in a reducing gas atmosphere.

Hereinafter, the present disclosure will be described with reference to the attached drawings.

FIG. 4 is a view illustrating a method for forming a crystalline vanadium dioxide thin film as a thermal sensing material for a thermography image sensor, in an embodiment of the present disclosure.

In the present disclosure, in forming a vanadium dioxide sensing material, vanadium oxytriisopropoxide (VTOP) may be first prepared as a V-containing precursor. The VTOP may be a well-known precursor generally used for forming a vanadium pentoxide (V₂O₅) thin film by deposition, and may be easily obtained on the market.

Next, in the present disclosure, the VTOP precursor and oxygen reaction gas may be sequentially injected into a chamber, and then an amorphous V₂O₅ thin film may be formed in a plasma state using a plasma enhanced atomic layer deposition (PE-ALD) method.

That is, by sequentially injecting a VTOP precursor and oxygen reaction gas into a chamber, and then forming an amorphous V₂O₅ oxide film on a substrate using plasma, an atomic layer deposition (ALD) method may be used to form the amorphous V₂O₅ oxide film on the substrate as one cycle.

Specifically, first, a VTOP precursor may be injected into a chamber to deposit a single atomic layer on a substrate, a remaining VTOP precursor may be discharged, and then oxygen reaction gas may be injected to react with the VTOP precursor, and then plasma may be generated to solidify bonding of the VTOP precursor and the oxygen, and a remaining unreacted gas may be discharged (purged). By repeating this procedure in the chamber (cycling), the film may be repeatedly stacked up to a desired thickness, and an amorphous V₂O₅ oxide film having a final desired thickness may be manufactured.

In the present disclosure, it is preferable to manage a thickness of the formed amorphous V₂O₅ oxide film in the range of 30 to 50 nm. When the thickness is too thin, a magnitude of thin film resistance may become too great and there may be a problem in connection with an electrode, and when the thickness is too thick, a temperature and time of reduction heat-treatment may increase to require an increase in process time and a temperature, equal to or higher than a process limit temperature (400°C), and there may be a problem in that a thermal time constant of a pixel is affected, slowing down an operation speed of the pixel.

In addition, in the present disclosure, a crystalline VO₂ oxide thin film may be manufactured by heat-treating the formed amorphous V₂O₅ oxide thin film in a rapid thermal anneal (RTA) furnace in a reducing gas atmosphere.

In the present disclosure, a post-heat-treatment temperature in the RTA may be controlled to 350°C or less.

In a case in which a vanadium metal thin film is manufactured using a conventional sputtering method and then post-heat-treated in a heat-treatment furnace maintained at a temperature range of 380 to 400°C, a volume of the heat-treatment furnace may be large, making it difficult to control a temperature and distribution of the reactive oxygen gas, and thus uniformity of a manufactured vanadium oxide (VOx) thin film may not be good.

In contrast, in the present disclosure, uniformity of the thin film may be excellent by post-heat-treating the amorphous V₂O₅ oxide thin film formed by the ALD method at a low temperature of 350°C or less in the RTA furnace, which may be advantageous in controlling a temperature and uniformity of the reactive gas, and a process time may be reduced.

Furthermore, in the present disclosure, the post-heat-treatment may be performed in a reducing gas atmosphere, thereby suppressing reoxidation of the thin film, and thus promoting the aforementioned advantages relative to the conventional technology. For example, in the conventional method of forming a thermal sensing material, the material may be used in a polymorph state in which various phases called VOx exist, and accordingly, there may be a problem of reoxidation when exposed to air for a long period of time, but in the method of forming a thermal sensing material of the present disclosure, since a material dominated by VO₂ may be created after RTA post-heat-treatment, there may be an advantage that reoxidation problems infrequently occur.

Use of a reducing gas may be important in the post-heat-treatment process of the present disclosure. In the past, oxygen or nitrogen was used in the post-heat-treatment process, and in this case, a temperature of about 500 to 600°C was required to reduce an amorphous V₂O₅ thin film to a crystalline VO₂ thin film, which was much higher than the process limit temperature of 400°C for ROIC, so there was a limitation that it could not be applied.

However, in the present disclosure, NH₃ gas with excellent reducing power may be used, and thus the heat-treatment temperature may be lowered to 350°C. Alternatively, nitrogen gas may be used as the reducing gas, and when heat-treatment is performed in a vacuum rather than an atmospheric pressure atmosphere, the heat-treatment may be performed at a temperature of about 400°C.

Therefore, in the present disclosure, it is preferable to use NH₃ gas or N₂ gas as the reducing gas used for the post-heat-treatment, and most preferably, NH₃ gas may be used.

Next, a method for manufacturing a thermography image sensor including a crystalline vanadium dioxide thin film, which may be the sensing material described above, will be described.

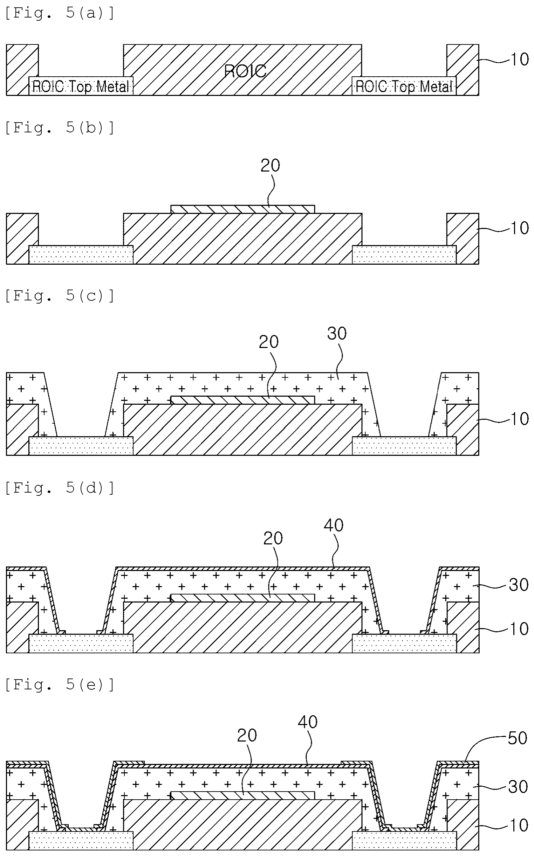

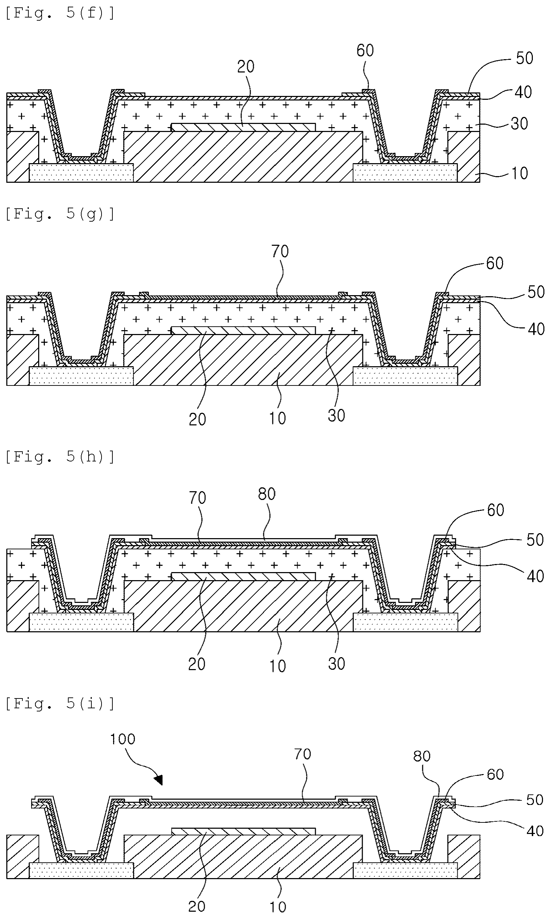

FIG. 5 is a process schematic diagram illustrating a method for manufacturing a thermography image sensor including the vanadium dioxide thin film manufactured in FIG. 4 as a sensing material, in an embodiment of the present disclosure.

First, as illustrated in FIG. 5(a), a read-out integrated circuit (ROIC) substrate 10 may be prepared, and then a reflective layer 20 may be formed on the ROIC substrate as illustrated in FIG. 5(b). The reflective layer 20 may be formed with various metals such as Au, Al, NiCr, or the like, and may be deposited with a thickness of approximately 200 nm by sputtering, an evaporator, or the like. In addition, a pattern may be formed by using an etching process or a lift-off process after a photoresist process.

Next, in the present disclosure, as illustrated in FIG. 5(c), a sacrificial layer 30 may be formed on the substrate on which the reflective layer 20 is formed, and then a VIA hole may be processed.

The sacrificial layer 30 may be formed by coating polyimide (PI) on the substrate, and a thickness of the sacrificial layer may be approximately 2 to 2.5 µm, based on a center wavelength of 10 µm, to create a λ/4 resonance structure of an infrared wavelength (8 to 14 µm) to be absorbed.

The VIA may be formed for connection with the lower electrode, and when a photo-sensitive polyimide (PSPI) is used to form the VIA, the formation may be completed with a general lithography (coating, exposure, development) process, and when general polyimide (PI) is used, the formation may be completed by coating and curing PI on the substrate, and then performing a lithography process using a photoresist in an upper portion of a PI film, and then performing dry etching using the photoresist as a mask.

Thereafter, as illustrated in FIG. 5(d), a support layer 40 may be formed on the substrate on which the sacrificial layer 30 is formed. The support layer 40 may be formed by depositing SiNx on the substrate by PECVD, and after the deposition, a VIA hole for connection with a lower electrode may be formed. To form the hole, a dry etching process may be performed after the photoresist process.

In the present disclosure, a thickness of the SiNx may be deposited from 100 nm to 300 nm depending on a pixel size, and a PECVD SiNx thin film needs to use a low-stress thin film of 50 to 150 MPa. In addition, the VIA hole of the support layer should be formed in the VIA hole of the sacrificial layer, and alignment of the holes may be important.

In addition, in the present disclosure, as illustrated in FIG. 5(e), an electrode layer 50 may be formed in a predetermined position on the substrate on which the support layer is formed. This electrode layer 50 may be formed using Ti or TiN with low thermal conductivity to connect a sensing layer and a lower electrode, described below. Specifically, it may be formed in a thickness range of 30 to 50 nm using a sputter deposition method with excellent step coverage, and a dry etching may be performed after a patterning process of the photoresist through a lithography process to form a pattern.

Next, in the present disclosure, as illustrated in FIG. 5(f), a VIA reinforcing layer 60 may be formed on an outer surface of the VIA hole on which the electrode layer 50 is formed. This may be to compensate for unstable electrical connection of metal of the electrode layer 50 inside the VIA hole. In this case, various metals such as Al, Au, Ni, and NiCr may be formed to a thickness of approximately 200 nm or more using a sputter deposition method with excellent step coverage, and the formation method may be performed by performing a lift-off process after the photoresist process and then depositing.

In the present disclosure, as illustrated in FIG. 5(g), a sensing layer 70 formed of a crystalline VO₂ oxide thin film may be formed on the substrate on which the VIA reinforcing layer 60 is formed using the above-described manufacturing method. That is, this sensing layer 70 may be manufactured using the ALD method. Specifically, the substrate on which the VIA reinforcing layer 60 is formed may be disposed in a chamber, and a VTOP precursor and oxygen reaction gas may be sequentially injected into the chamber using a plasma enhanced atomic layer deposition (PE-ALD) method, and then an amorphous V₂O₅ thin film may be formed in a plasma state. Then, the substrate on which the amorphous V₂O₅ oxide thin film is formed may be heat-treated in a rapid thermal anneal (RTA) furnace in a reducing gas atmosphere, thereby manufacturing a crystalline VO₂ oxide thin film as the sensing layer 70, and subsequently, the formed sensing layer 70 may be formed into a predetermined pattern through a conventional lithography process and an etching process. A detailed description thereof may be as described above.

Next, in the present disclosure, as illustrated in FIG. 5(h), a protective layer 80 may be formed on the substrate on which the sensing layer 70 is formed. This may be a layer for protecting the sensing layer 70, the electrode layer 50, or the like, and SiNx may be deposited to a predetermined thickness using PECVD, and a microbolometer pixel-shaped pattern may be performed after the deposition is completed. The pattern may be formed by performing dry etching of SiNx after the lithography process.

In the present disclosure, a thickness of the SiNx may be deposited from 70 nm to 200 nm depending on a pixel size, and the PECVD SiNx thin film needs to use a low-stress thin film of 50 to 150 MPa.

Finally, in the present disclosure, as illustrated in FIG. 5(i), by removing the sacrificial layer 30 from the substrate on which the protective layer 80 is formed, a thermography image sensor 100 in which the sensing layer 70 exists in a floating form by the support layer 40 or the like may be manufactured.

In the present disclosure, removal of the sacrificial layer 30 may be performed using oxygen plasma in a microwave asher, and a temperature of the substrate during the process is preferably 80 to 250°C. As the temperature of the substrate increases, a removal speed of PI may increase, but problems such as deformation or the like of an SiNx film or a lower reflective layer may occur.

Therefore, a thermography image sensor 100 of the present disclosure includes, as illustrated in FIG. 5(i), a ROIC substrate; a reflective layer formed on the ROIC substrate; a sensing layer formed in a space above the reflective layer; a support layer formed on a lower surface of the sensing layer to support the sensing layer; and a protective layer formed on an upper surface of the sensing layer, in which the support layer may be configured such that the sensing layer has a structure in which the space is floated, and the sensing layer is characterized by being formed of a crystalline VO₂ oxide thin film manufactured by the manufacturing method.

### Mode for Invention

Hereinafter, the present disclosure will be described in detail through examples.

### (Example)

An ROIC substrate was disposed in a chamber, and a VTOP precursor and oxygen reaction gas were sequentially injected into the chamber using a plasma enhanced atomic layer deposition (PE-ALD) method, and an amorphous V₂O₅ thin film with a thickness of 30 to 50 nm was deposited in a plasma state. Specific ALD deposition conditions were as follows: a substrate temperature of 80 to 150°C, a VTOP injection time of 0.5 to 2 seconds, a VTOP purging time of 3 to 15 seconds, an oxygen injection time of 1 to 3 seconds, a plasma time of 1 to 3 seconds, an oxygen purging time of 2 to 15 seconds, an RF power of 30 to 100 W, a process pressure of 0.5 to 2 torr, and a process cycle of 300 to 700 cycles.

The substrate on which the amorphous V₂O₅ oxide thin film was formed was heat-treated at 350°C in a rapid thermal anneal (RTA) furnace in a reducing gas atmosphere containing ammonia gas, thereby producing a crystalline VO₂ oxide thin film with a final thickness of 30 to 50nm. In this case, heat-treatment conditions were as follows: a process pressure of 200 to 600 mtorr, a process temperature of 350 to 380°C, a process time of 0.5 hour, and a reducing gas of NH₃.

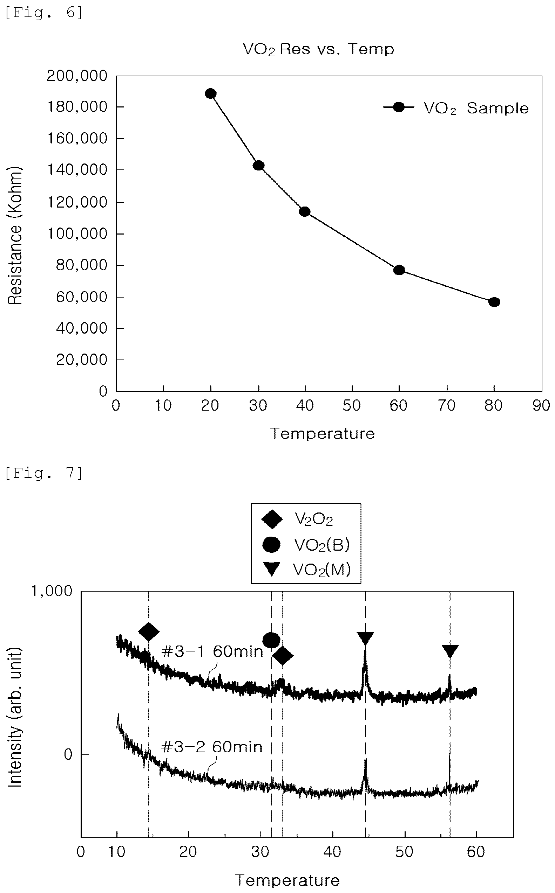

To evaluate characteristics of the crystalline VO₂ oxide thin film manufactured as described above, a resistance change rate, a composition, and uniformity of the thin film were measured, and results were illustrated in FIGS. 6 to 8.

Specifically, in this embodiment, a resistance change rate of the crystalline VO₂ oxide thin film was measured by measuring I-V curves at each substrate temperature and converting its values into resistance, and results were illustrated in FIG. 6.

A composition of the crystalline VO₂ oxide thin film was measured using an XRD analysis method, and results were illustrated in FIG. 7.

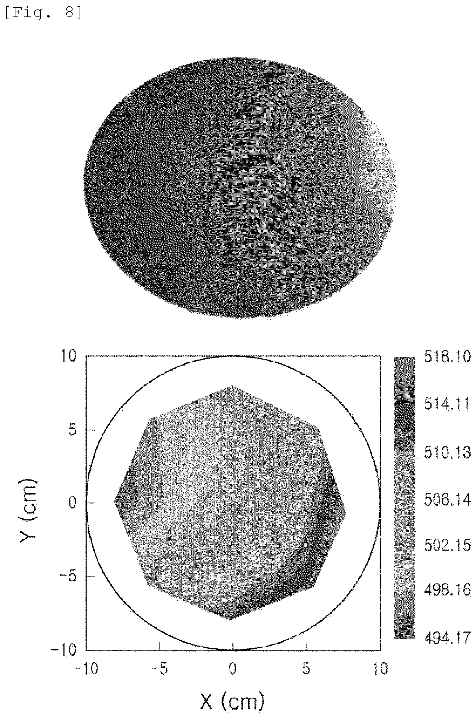

In addition, thickness uniformity of the V₂O₅ oxide thin film was evaluated using an ellipsometer, and results were illustrated in FIG. 8.

FIG. 6 is a view illustrating a resistance change rate of a vanadium dioxide thin film manufactured in an embodiment of the present disclosure, FIG. 7 is a view illustrating a composition of a vanadium dioxide thin film manufactured in an embodiment of the present disclosure, and FIG. 8 is a view illustrating thickness uniformity of a vanadium dioxide thin film manufactured in an embodiment of the present disclosure.

As illustrated in FIG. 6, in a crystalline VO₂ oxide thin film manufactured by the manufacturing method of the present disclosure, a resistance change rate was about -3%/K, which was superior to about -2%/K of a thin film manufactured by a conventional technique.

Also, as illustrated in FIG. 7, in a crystalline VO₂ oxide thin film manufactured by the manufacturing method of the present disclosure, it can be seen that a VO₂(M) phase was dominantly present.

As illustrated in FIG. 8, in a V₂O₅ oxide thin film of the present disclosure formed by deposition with a thickness of 50 nm using an ALD method, it can be seen that thickness uniformity was very excellent at 2.36%.

As described above, the detailed description of the present disclosure has described preferred embodiments of the present disclosure, but it may be obvious that various modifications are possible within the scope of the present disclosure by those skilled in the art to which the present disclosure pertains. Therefore, the scope of the rights of the present disclosure should not be limited to the described embodiments, but should be determined by not only the claims described below but also equivalents thereof.

## Claims

1. A method for manufacturing a sensing material for a thermography image sensor, comprising:
preparing a VTOP precursor;
sequentially injecting the VTOP precursor and oxygen reaction gas into a chamber, and then forming an amorphous V₂O₅ oxide thin film in a plasma state using a plasma enhanced atomic layer deposition (PE-ALD) method; and
preparing a crystalline VO₂ oxide thin film by heat-treating the formed amorphous V₂O₅ oxide thin film in a rapid thermal anneal (RTA) furnace in a reducing gas atmosphere.

2. The method of claim 1, wherein NH₃ gas or N₂ gas is used as the reducing gas.

3. The method of claim 1, wherein a heat-treatment temperature in the RTA furnace is 350°C or lower.

4. The method of claim 2, wherein NH₃ gas is used as the reducing gas.

5. The method of claim 1, wherein thickness uniformity of the prepared crystalline VO₂ oxide thin film is 3% or less on a large-area substrate.

6. The method of claim 1, wherein a resistance change rate of the prepared crystalline VO₂ oxide thin film is -3%/K or higher.

7. A thermography image sensor comprising:
an ROIC substrate;
a reflective layer formed on the ROIC substrate;
a sensing layer formed in a space above the reflective layer;
a support layer formed on a lower surface of the sensing layer to support the sensing layer; and
a protective layer formed on an upper surface of the sensing layer,
wherein the support layer is configured such that the sensing layer can have a structure in which the space is floated, and
the sensing layer is formed as the crystalline VO₂ oxide thin film manufactured by the method of any one of claims 1 to 6.

8. A method for manufacturing a thermography image sensor, comprising:
preparing a ROIC substrate;
forming a reflective layer on the ROIC substrate;
forming a sacrificial layer on the substrate on which the reflective layer is formed, and then processing a VIA hole;
forming a support layer on the formed sacrificial layer;
forming an electrode layer at a predetermined position on the substrate on which the support layer is formed;
forming a VIA reinforcing layer on an outer surface of the VIA hole on which the electrode layer is formed;
forming a crystalline VO₂ oxide thin film, which is a sensing layer, on the substrate on which the VIA reinforcing layer is formed;
forming a protective layer on the substrate on which the sensing layer is formed; and
removing the sacrificial layer,
wherein the crystalline Vo₂ oxide thin film, which is the sensing layer, is manufactured by a process including:
disposing the substrate on which the VIA reinforcing layer is formed in a chamber, sequentially injecting a VTOP precursor and oxygen reaction gas into the chamber, and then forming an amorphous V₂O₅ oxide thin film in a plasma state using a plasma enhanced atomic layer deposition (PE-ALD) method;
forming the crystalline Vo₂ oxide thin film, which is the sensing layer, by heat-treating the substrate on which the amorphous V₂O₅ oxide thin film is formed in a rapid thermal anneal (RTA) furnace in a reducing gas atmosphere; and
forming the formed sensing layer as a pattern through a lithography process and an etching process.

9. The method of claim 8, wherein NH₃ gas or N₂ gas is used as the reducing gas.

10. The method of claim 8, wherein a heat-treatment temperature in the RTA furnace is 350°C or lower.

11. The method of claim 9, wherein NH₃ gas is used as the reducing gas.

12. The method of claim 8, wherein thickness uniformity of the prepared crystalline VO₂ oxide thin film is 3% or less, and
a resistance change rate is -3%/K or higher.
